# EUROPEAN PATENT APPLICATION

(11) **EP 4 613 725 A1**
(43) Date of publication of application: **10.09.2025**
(21) Application number: 23885592.8
(22) Date of filing: 24.10.2023
(51) Int. Cl.: C04B 35/591, H01L 23/15

(54) **SINTERED SILICON NITRIDE OBJECT**

(30) Priority: 02.11.2022 JP 2022176363
(71) Applicant: TOKUYAMA CORPORATION, Yamaguchi 745-8648 (JP)
(72) Inventor: ISHIMOTO, Ryuji, Shunan-shi, Yamaguchi 745-8648 (JP); KUSANO, Dai, Shunan-shi, Yamaguchi 745-8648 (JP)
(74) Representative: Kraus & Lederer PartGmbB
(86) International application number: PCT/JP2023/038378
(87) International publication number: WO 2024/095834

(57) **Abstract**

The silicon nitride sintered body according to the present invention contains at least one element selected from the group consisting of Ti, Ge, Zr, Ag, Ba, and Hf in silicon nitride grains constituting the sintered body, and the at least one element is contained as a solid solution in the silicon nitride grains at a concentration of 0.01% to 0.15% by mass. The present invention provides a silicon nitride sintered body having a greatly smaller decrease in volume resistivity at high temperatures with respect to volume resistivity at room temperature than conventional silicon nitride sintered bodies.

## Description

### Technical Field

The present invention relates to a novel silicon nitride sintered body. More particularly, the present invention provides a silicon nitride sintered body having a greatly smaller decrease in volume resistivity at high temperatures with respect to volume resistivity at room temperature.

### Background Art

Silicon nitride sintered bodies have been gaining attention as various industrial materials because of their excellent properties such as high thermal conductivity, high insulation, and high strength. The volume resistivity of such silicon nitride sintered bodies is high at room temperature, but is markedly decreased at high temperatures. For this reason, silicon nitride sintered bodies may fail to maintain sufficient insulation resistance when used as substrates for power modules and other devices used at operating temperatures up to 200°C or more.

A previous report describes that a silicon nitride sintered body-based circuit board with circuit patterns formed thereon is heated in a nitrogen atmosphere for reducing the extent of decrease in volume resistivity at high temperatures, to achieve an improved electrical insulation at high temperatures (see PTL 1). Another disclosure is that a silicon nitride sintered body containing a predetermined amount of Mg or predetermined amounts of Mg and Y₂O₃ has high electrical insulation at high temperatures; and the mechanism of this effect is presumed to be due to solid solution of these elements in silicon nitride crystal grains or to dissolved MgO covering crystal grains constituting the sintered body (see PTL 2).

However, neither of the silicon nitride sintered bodies mentioned above sufficiently achieved a smaller decrease in volume resistivity at high temperatures, and there is room for further improvement.

### Citation List

### Patent Literature

PTL 1: JP 2001-77245 A
PTL 2: JP 2001-64080 A

### Summary of Invention

### Technical Problem

Therefore, an object of the present invention is to provide a silicon nitride sintered body having a greatly smaller decrease in volume resistivity at high temperatures with respect to volume resistivity at room temperature than conventional silicon nitride sintered bodies.

### Solution to Problem

The present inventors conducted intensive and extensive investigations to achieve this object, and finally found that solid solution of a specific element in a specific amount in silicon nitride crystal grains constituting a silicon nitride sintered body can effectively reduce the extent of decrease in volume resistivity at high temperatures. The present invention is thus completed.

That is, the present invention provides a silicon nitride sintered body containing at least one element selected from the group consisting of Ti, Ge, Zr, Ag, Ba, and Hf in silicon nitride grains constituting the sintered body, the at least one element being contained as a solid solution in the silicon nitride grains at a concentration of 0.01% to 0.15% by mass.

In the silicon nitride sintered body, the total concentration of elements P, Cr, Mn, and Fe contained as a solid solution in the silicon nitride grains is preferably adjusted to 0.05% by mass or less, because this can further reduce the extent of decrease in volume resistivity at high temperatures.

### Advantageous Effects of Invention

The silicon nitride sintered body according to the present invention not only has high volume resistivity at room temperature, but also can maintain such high volume resistivity at practical operating temperatures in applications as substrates for power modules and other devices, and thus can maintain sufficient insulation resistance when used in such applications.

### Description of Embodiments

In the present invention, the silicon nitride sintered body contains silicon nitride in an amount of preferably 80% by mass or more, and particularly preferably 90% by mass or more. The total elemental aluminum content (mass) is preferably 800 ppm or less. This achieves the silicon nitride sintered body having high thermal conductivity. The total elemental aluminum content (mass) is preferably 500 ppm or less, and more preferably 200 ppm or less.

The most distinctive feature of the silicon nitride sintered body according to the present invention is that at least one element selected from the group consisting of Ti, Ge, Zr, Ag, Ba, and Hf (hereinafter also referred to as a specific first element) is contained as a solid solution in silicon nitride grains constituting the sintered body at a concentration of 0.01% to 0.15% by mass, preferably 0.03% to 0.12% by mass. In this concentration range of the solid solution element, the respective amounts of the specific first elements contained as a solid solution are 0.01% by mass or more, and preferably 0.03% by mass or more. One of the specific first elements may be used alone, or two or more of them may be used in combination. When two or more specific first elements are used in combination, the amount of the specific first element is understood to mean the total amount of the two or more elements.

Of the specific first elements, at least one element selected from the group consisting of Zr and Hf is particularly preferable.

In the present invention, the methods shown below can be used to confirm the presence of an element contained as a solid solution in the silicon nitride grains and to measure the concentration of the element, although a more specific description will be given in the examples later.

### (1) Confirmation of the presence of an element contained as a solid solution in the silicon nitride grains

The term "solid solution" refers to a state in which, using silicon nitride grains as an example, an element other than nitrogen and silicon is present in the intragrain of individual silicon nitride grains without precipitating in an elemental form or a compound form. The presence of the element in the silicon nitride grains in such a state can be confirmed by observation for the presence or absence of precipitates in the intragrain of the silicon nitride grains using a transmission electron microscope (TEM) and by elemental analysis of the intragrain of the silicon nitride grains using an energy dispersive X-ray spectrometer (EDS) mounted on the TEM.

### (2) Measurement of the concentration of the element contained as a solid solution in the silicon nitride grains

The concentration of the element contained as a solid solution in the silicon nitride grains can be measured by qualitative and quantitative analysis of the element using an EDS.

The silicon nitride sintered body according to the present invention contains the specific first element at the specific concentration in the silicon nitride grains constituting the sintered body, so that the extent of decrease in volume resistivity at high temperatures can be markedly reduced, enabling the silicon nitride sintered body to maintain high volume resistivity even in high-temperature applications, for example, as substrates for power modules as mentioned above. That is, when the concentration of the specific first element in the silicon nitride grains constituting the sintered body is lower than the range described above, the effect of reducing the extent of decrease in volume resistivity at high temperatures is so insufficient that the silicon nitride sintered body could not achieve high volume resistivity at high temperatures. When the concentration of the specific first element is higher than the range described above, the extent of decrease in volume resistivity at high temperatures is reduced, but the silicon nitride sintered body tends to have problems such as low thermal conductivity and poor insulation.

The specific first element is desirably uniformly distributed among the individual silicon nitride grains constituting the sintered body, and is preferably present in 80% or more, more preferably 90% or more of the number of silicon nitride grains observed using a TEM as mentioned above.

As long as the silicon nitride sintered body according to the present invention satisfies the configuration described above, other configurations are not particularly limited. Preferable embodiments are as follows.

In the silicon nitride sintered body according to the present invention, a solid solution element other than the specific first element is preferably present in a smaller amount. In particular, the total concentration of elements P, Cr, Mn, and Fe (hereinafter also referred to as a specific second element) contained as a solid solution in the silicon nitride grains is preferably 0.05% by mass or less, and particularly preferably 0.02% by mass or less.

The silicon nitride grains constituting the silicon nitride sintered body according to the present invention are preferably crystal grains of silicon nitride. The average grain size (average major-axis length) is not particularly limited, and is preferably 1 to 5 µm, particularly preferably 3 to 5 µm to achieve high thermal conductivity of the silicon nitride sintered body.

In addition, the average aspect ratio of the silicon nitride grains is not particularly limited, and is preferably 1.2 to 2.5, particularly preferably about 1.7 to 2.5 to achieve high strength of the silicon nitride sintered body.

Furthermore, in the grain boundary phases or triple junctions in the silicon nitride grains constituting the silicon nitride sintered body, a phase of a compound derived from the aid component used for firing may be present.

The shape of the silicon nitride sintered body according to the present invention is not particularly limited, and in applications as substrates for power modules and other devices as mentioned above, the silicon nitride sintered body is in the form of a plate. The thickness of the plate is generally 0.1 to 1 mm, particularly about 0.2 to 0.7 mm.

The method for producing the silicon nitride sintered body according to the present invention is not particularly limited, and typically includes the steps of: preparing a silicon nitride powder containing a specific first element contained as a solid solution therein and firing the silicon nitride powder to obtain a sintered body.

The feature of this production method is that the specific first element is not added in the process of sintering of silicon nitride powder, but solidly-soluted in silicon nitride powder in advance. In the case of adding the specific first element to silicon nitride powder in the process of sintering, the specific first element is less likely to be contained as a solid solution in silicon nitride grains constituting a sintered body and is more likely to be present in the grain boundaries. As a result, the silicon nitride sintered body obtained in this manner has an insufficient concentration of the specific first element contained as a solid solution in the silicon nitride grains constituting the sintered body, and fails to maintain high volume resistivity at high temperatures.

The method for obtaining the silicon nitride powder containing a specific first element contained as a solid solution therein is not particularly limited, and the examples thereof include, in the process of producing silicon nitride powder by combustion synthesis, the aspect in which a compound of the specific first element, specifically an oxide or nitride thereof, may be added to silicon as a raw material and subjected to the reaction, and the aspect in which a compound of the specific first element may be added to silicon nitride powder or lumps, and solidly-soluted with heating at 600°C to 1,600°C, and optionally, grinding may be performed.

The method relying on combustion synthesis is preferable because of its easy production of a silicon nitride powder containing an element as a solid solution therein. In this method, silicon powder is used as a raw material, part of the raw material powder is subjected to forced ignition under a nitrogen atmosphere, and due to self-heating of the raw material compound, silicon nitride is synthesized. The combustion synthesis is a well-known method, and can be found, for example, in JP2000-264608A, WO2019/167879, etc.

The concentration of the specific first element contained as a solid solution in the finally obtained silicon nitride sintered body can be adjusted by manipulating the concentration of the specific first element to be solidly-soluted in the silicon nitride powder.

On the other hand, the examples of method for reducing the concentration of the specific second element contained as a solid solution in the silicon nitride powder and thus in the finally obtained silicon nitride sintered body, include the aspect in which a high-purity raw material in which an element other than the specific first element is present as little as possible may be used for the production of silicon nitride powder as a raw material for sintering, and the aspect to prevent the reactants from direct contact with materials containing the specific second element that are components of the grinding media, containers, or conveyance pipes used in the production of silicon nitride powder.

In the method for producing the silicon nitride sintered body, the crystal form of the silicon nitride powder used is not particularly limited, and α- and β-silicon nitride powder can be used singly or in combination.

The average particle size of the silicon nitride powder is preferably 0.5 to 3 µm, and particularly preferably 0.7 to 1.7 µm. The oxygen content of the silicon nitride powder is preferably about 0.5% to 1.5% by mass.

In the method for producing the silicon nitride sintered body, the method for firing the silicon nitride powder to produce a silicon nitride sintered body is not limited, and conventional methods can be used without any particular limitations.

For example, the method in which a formed body of a raw material mixture containing the silicon nitride powder and a sintering aid may be fired in the presence of an inert gas such as nitrogen gas or argon gas at a pressure of 0 to 0.1 MPa·G at a temperature of 1,200°C or more and less than the decomposition temperature of silicon nitride at the above pressure for 2 to 30 hours, is given.

The sintering aid used can be a known sintering aid such as an oxide or carbonitride of yttrium, magnesium, or cerium. The amount of the sintering aid used is preferably 5 to 20 parts by mass, particularly preferably 7 to 10 parts by mass per 100 parts by mass of the silicon nitride powder.

In the production process of the formed body, binders such as polyvinyl alcohol, polyvinyl butyral, methyl cellulose, alginic acid, polyethylene glycol, carboxymethyl cellulose, ethyl cellulose, and acrylic resin can also be used. The amount of the binder used is preferably 1 to 30 parts by mass per 100 parts by mass of the silicon nitride powder, and may be determined according to the forming method.

Furthermore, in the forming process using a binder, a slurry can be prepared using a solvent such as water, an alcohol, or a hydrocarbon, formed into a sheet or other shapes by the doctor blade method or other forming methods, and as needed, dried and dewaxed before being subjected to firing.

When a substrate is produced by the method for producing the silicon nitride sintered body according to the present invention, the surface after the firing can be, for example, cleaned by blasting with abrasive grains such as silicon nitride powder or polished.

### Examples

Hereinafter, examples are provided to describe the present invention in more detail, but the present invention is not limited thereto.

The measurements in the examples and comparative examples were performed by the following methods.

### (1) Concentrations of the elements contained as a solid solution in the silicon nitride sintered body

The concentrations of the elements contained as a solid solution in the silicon nitride sintered body were determined by TEM-EDS measurement. The apparatus used was a TEM JEM-2100 manufactured by JEOL Ltd. equipped with a EDS JED-2300 manufactured by JEOL Ltd. A total of 30 randomly selected silicon nitride grains in the silicon nitride sintered body were observed using the TEM, and qualitative and quantitative analysis of each element was performed by EDS spot analysis. The average of the analytical values of the 30 grains was used as the concentration of the element contained as a solid solution in the silicon nitride sintered body. However, when even one of the 30 silicon nitride grains observed using the TEM contained intragranular precipitates, the concentrations of the elements contained as a solid solution therein were regarded as unmeasurable. The accelerating voltage of the TEM was 200 kV, and the EDS measurement time per grain was 1,000 seconds.

### (2) Percentage of the number of the silicon nitride grains containing the specific first element as a solid solution therein in the silicon nitride sintered body.

The percentage of the number of the silicon nitride grains containing the specific first element as a solid solution therein in the silicon nitride sintered body was calculated as the ratio of the number of the silicon nitride grains in which at least one specific first element was detected in the EDS analysis to the 30 silicon nitride grains observed using the TEM. However, when silicon nitride grains were confirmed to contain intragranular precipitates by TEM observation, these grains were counted as containing no elements as a solid solution therein. The detection lower limit of the specific first element in the EDS analysis was 0.005% by mass.

### (3) Total elemental aluminum content of the silicon nitride sintered body

The total elemental aluminum content of the silicon nitride sintered body was measured using an inductively coupled plasma optical emission spectrometer (iCAP 6500DUO, Thermo Fisher Scientific, Inc.).

### (4) Volume resistivities at room temperature and 450°C

The volume resistivities at room temperature (25°C) and 450°C were determined by volume resistivity measurement in accordance with JIS C2141 using an evaluation device made by combining a micro current meter and an electric furnace. The measurement was performed in a nitrogen gas atmosphere at an applied voltage of 500 V. In the case of measurement at 450°C, the temperature was raised to 450°C at a temperature increment rate of 20°C/min and kept for 15 min before measurement.

### Examples 1 to 22, Comparative Examples 1 and 2

Silicon powder (semiconductor grade, average particle size: 5 µm) and silicon nitride powder (average particle size: 1.5 µm) as a diluent were mixed in amounts of 80% by mass and 20% by mass, respectively. This powder mixture was mixed with oxide(s) of the element(s) shown in Table 1 in the amount(s) shown in Table 1, and a raw material powder was obtained.

The raw material powder was placed in a reaction vessel and allowed to form a raw material powder layer. The reaction vessel was then placed in a pressure-resistant sealed reactor with an ignition device and a gas supply and exhaust system. The reactor was depressurized and degassed, and then supplied with nitrogen gas for nitrogen purging. Thereafter, nitrogen gas was gradually supplied until the pressure increased to 0.7 MPa. The bulk density of the raw material powder was 0.5 g/cm³ at the time point when the pressure reached the predetermined level (at ignition). The edge of the layer of the raw material powder in the reaction vessel was then ignited for a combustion synthesis reaction to proceed, and a lumpy product containing silicon nitride was obtained. An appropriate amount of the obtained lumpy product was put into a vibration mill and finely ground for 6 hours. The fine grinding mill and fine grinding method used were the usual apparatus and method. The inner surface of the mill was lined with urethane to prevent metal contamination, and the grinding medium used was silicon nitride-based balls. In addition, ethanol was added in an amount of 1% by mass as a grinding aid just before the start of fine grinding. After fine grinding, silicon nitride powder was obtained.

The obtained silicon nitride powder contained β-silicon nitride, and the average particle size was about 1.8 µm after the fine grinding.

A hundred parts by mass of the silicon nitride powder obtained in the manner described above, 2 parts by mass of Y₂Si₄N₆C, 5 parts by mass of MgSi₄N₆C, both of which are compounds without no oxygen bonds, and 3 parts by mass of yttria were weighed. These materials were mixed and ground in a ball mill using a resin pot, silicon nitride balls, and water as a dispersion medium for 24 hours. The water was weighed such that the slurry concentration would be 60% by mass and placed in the resin pot in advance. After grinding and mixing, 22 parts by mass of an aqueous resin binder was added, and mixing was continued for another 12 hours. After that, a slurry composition as a forming material was obtained. The composition as a forming material was then formed into a sheet by the doctor blade method, and a sheet-formed body having a width of 75 cm and a thickness of 0.3 mmt was obtained. The obtained sheet-formed body was then dewaxed in dry air at a temperature of 550°C. The dewaxed formed body was placed in a firing vessel and fired at 1,780°C under a nitrogen atmosphere and a pressure of 0.02 MPa·G for 9 hours. After that, a silicon nitride sintered body was obtained. The total elemental aluminum content of the obtained silicon nitride sintered body was 200 ppm. The amount of each element contained as a solid solution in the obtained silicon nitride sintered body, as well as the volume resistivities at room temperature and at 450°C, are shown in Table 2.

### [Table 1]

**Table 1**

| | Raw material powder | | | | | | | | | | | |
|---|---|---|---|---|---|---|---|---|---|---|---|---|
| | Silicon Si (pbm) | Diluent Si₃N₄ (pbm) | Added element (amount relative to total amount of silicon and diluent: % by mass) | | | | | | | | | |
| | | | Specific first element | | | | | | Specific second element | | | |
| | | | Ti | Ge | Zr | Ag | BaSO₄ | Hf | Na₃PO₄ | Cr | Mn | Fe |
| Ex. 1 | 80 | 20 | 0.03 | - | - | - | - | - | - | - | - | - |
| Ex. 2 | 80 | 20 | - | 0.03 | - | - | - | - | - | - | - | - |
| Ex. 3 | 80 | 20 | - | - | 0.03 | - | - | - | - | - | - | - |
| Ex. 4 | 80 | 20 | - | - | - | 0.03 | - | - | - | - | - | - |
| Ex. 5 | 80 | 20 | - | - | - | - | 0.22 | - | - | - | - | - |
| Ex. 6 | 80 | 20 | - | - | - | - | - | 0.03 | - | - | - | - |
| Ex. 7 | 80 | 20 | 0.10 | - | - | - | - | - | - | - | - | - |
| Ex. 8 | 80 | 20 | - | 0.10 | - | - | - | - | - | - | - | - |
| Ex. 9 | 80 | 20 | - | - | 0.10 | - | - | - | - | - | - | - |
| Ex. 10 | 80 | 20 | - | - | - | 0.10 | - | - | - | - | - | - |
| Ex. 11 | 80 | 20 | - | - | - | - | 0.73 | - | - | - | - | - |
| Ex. 12 | 80 | 20 | - | - | - | - | - | 0.10 | - | - | - | - |
| Ex. 13 | 80 | 20 | 0.03 | 0.03 | 0.03 | 0.03 | 0.22 | 0.03 | - | - | - | - |
| Ex. 14 | 80 | 20 | 0.05 | - | - | - | - | - | - | 0.05 | - | - |
| Ex. 15 | 80 | 20 | - | - | - | - | - | 0.10 | 0.03 | - | - | - |
| Ex. 16 | 80 | 20 | - | - | - | - | - | 0.10 | - | 0.03 | - | - |
| Ex. 17 | 80 | 20 | - | - | - | - | - | 0.10 | - | - | 0.03 | - |
| Ex. 18 | 80 | 20 | - | - | - | - | - | 0.10 | - | - | - | 0.03 |
| Ex. 19 | 80 | 20 | - | - | - | - | - | 0.10 | 0.53 | - | - | - |
| Ex. 20 | 80 | 20 | - | - | - | - | - | 0.10 | - | 0.10 | - | - |

| | | | | | | | | | | | | |
|---|---|---|---|---|---|---|---|---|---|---|---|---|
| Ex.: Example, pbm: parts by mass | | | | | | | | | | | | |

**Table 1 (continued)**

| | Raw material powder | | | | | | | | | | | |
|---|---|---|---|---|---|---|---|---|---|---|---|---|
| | Silicon Si (pbm) | Diluent Si₃N₄ (pbm) | Added element (amount relative to total amount of silicon and diluent: % by mass) | | | | | | | | | |
| | | | Specific first element | | | | | | Specific second element | | | |
| | | | Ti | Ge | Zr | Ag | BaSO₄ | Hf | Na₃PO₄ | Cr | Mn | Fe |
| Ex. 21 | 80 | 20 | - | - | - | - | - | 0.10 | - | - | 0.10 | - |
| Ex. 22 | 80 | 20 | - | - | - | - | - | 0.10 | - | - | - | 0.10 |
| CEx. 1 | 80 | 20 | - | - | - | - | - | - | - | - | - | - |
| CEx. 2 | 80 | 20 | 0.08 | 0.08 | 0.08 | 0.08 | 0.58 | 0.08 | - | - | - | - |

| | | | | | | | | | | | | |
|---|---|---|---|---|---|---|---|---|---|---|---|---|
| Ex.: Example, CEx.: Comparative Example, pbm: parts by mass | | | | | | | | | | | | |

### [Table 2]

**Table 2**

| | Concentration of solid solution element (% by mass) | | | | | | | | | | Volume resistivity (Ω·cm) | | Percentage of number of grains containing specific first element (%) |
|---|---|---|---|---|---|---|---|---|---|---|---|---|---|
| | Specific first element | | | | | | Specific second element | | | | | | |
| | Ti | Ge | Zr | Ag | Ba | Hf | P | Cr | Mn | Fe | RT | 450°C | |
| Ex. 1 | 0.02 | ND | ND | ND | ND | ND | ND | ND | ND | ND | 7.9×10¹⁴ | 4.2×10¹² | 90 |
| Ex. 2 | ND | 0.02 | ND | ND | ND | ND | ND | ND | ND | ND | 8.1×10¹⁴ | 4.4×10¹² | 90 |
| Ex. 3 | ND | ND | 0.02 | ND | ND | ND | ND | ND | ND | ND | 8.4×10¹⁴ | 4.9×10¹² | 90 |
| Ex. 4 | ND | ND | ND | 0.02 | ND | ND | ND | ND | ND | ND | 7.5×10¹⁴ | 3.7×10¹² | 93 |
| Ex 5 | ND | ND | ND | ND | 0.02 | ND | ND | ND | ND | ND | 7.6×10¹⁴ | 4.0×10¹² | 90 |
| Ex. 6 | ND | ND | ND | ND | ND | 0.02 | ND | ND | ND | ND | 8.3×10¹⁴ | 4.7×10¹² | 93 |
| Ex. 7 | 0.08 | ND | ND | ND | ND | ND | ND | ND | ND | ND | 8.9×10¹⁴ | 6.5×10¹² | 100 |
| Ex. 8 | ND | 0.08 | ND | ND | ND | ND | ND | ND | ND | ND | 9.0×10¹⁴ | 6.6×10¹² | 100 |
| Ex. 9 | ND | ND | 0.08 | ND | ND | ND | ND | ND | ND | ND | 9.3×10¹⁴ | 7.1×10¹² | 100 |
| Ex. 10 | ND | ND | ND | 0.07 | ND | ND | ND | ND | ND | ND | 8.7×10¹⁴ | 6.1×10¹² | 100 |
| Ex. 11 | ND | ND | ND | ND | 0.06 | ND | ND | ND | ND | ND | 8.8×10¹⁴ | 6.2×10¹² | 100 |
| Ex. 12 | ND | ND | ND | ND | ND | 0.08 | ND | ND | ND | ND | 9.2×10¹⁴ | 6.9×10¹² | 100 |
| Ex. 13 | 0.02 | 0.02 | 0.02 | 0.02 | 0.02 | 0.02 | ND | ND | ND | ND | 8.9×10¹⁴ | 8.6×10¹² | 100 |
| Ex. 14 | 0.04 | ND | ND | ND | ND | ND | ND | 0.04 | ND | ND | 7.9×10¹⁴ | 1.0×10¹² | 97 |
| Ex. 15 | ND | ND | ND | ND | ND | 0.08 | 0.02 | ND | ND | ND | 5.7×10¹⁴ | 2.4×10¹¹ | 100 |
| Ex. 16 | ND | ND | ND | ND | ND | 0.08 | ND | 0.02 | ND | ND | 6.2×10¹⁴ | 4.8×10¹¹ | 100 |
| Ex. 17 | ND | ND | ND | ND | ND | 0.08 | ND | ND | 0.02 | ND | 6.1×10¹⁴ | 4.3×10¹¹ | 100 |
| Ex. 18 | ND | ND | ND | ND | ND | 0.08 | ND | ND | ND | 0.02 | 5.9×10¹⁴ | 2.9×10¹¹ | 100 |
| Ex. 19 | ND | ND | ND | ND | ND | 0.08 | 0.06 | ND | ND | ND | 2.8×10¹⁴ | 1.3×10¹¹ | 100 |
| Ex. 20 | ND | ND | ND | ND | ND | 0.08 | ND | 0.08 | ND | ND | 2.1×10¹⁴ | 1.6×10¹¹ | 100 |

| | | | | | | | | | | | | | |
|---|---|---|---|---|---|---|---|---|---|---|---|---|---|
| Ex.: Example, RT: Room temperature | | | | | | | | | | | | | |

**Table 2 (continued)**

| | Concentration of solid solution element (% by mass) | | | | | | | | | | Volume resistivity (Ω·cm) | | Percentage of number of grains containing specific first element (%) |
|---|---|---|---|---|---|---|---|---|---|---|---|---|---|
| | Specific first element | | | | | | Specific second element | | | | | | |
| | Ti | Ge | Zr | Ag | Ba | Hf | P | Cr | Mn | Fe | RT | 450°C | |
| Ex. 21 | ND | ND | ND | ND | ND | 0.08 | ND | ND | 0.07 | ND | 1.9×10¹⁴ | 1.4x10¹¹ | 100 |
| Ex. 22 | ND | ND | ND | ND | ND | 0.08 | ND | ND | ND | 0.08 | 1.6×10¹⁴ | 1.0×10¹¹ | 100 |
| CEx. 1 | ND | ND | ND | ND | ND | ND | ND | ND | ND | ND | 7.2×10¹⁴ | 6.1×10¹⁰ | 0 |
| CEx. 2 | Concentrations of solid solution elements were unmeasurable due to intragranular precipitation | | | | | | | | | | 2.7×10⁹ | - | 0 |

| | | | | | | | | | | | | | |
|---|---|---|---|---|---|---|---|---|---|---|---|---|---|
| Ex.: Example, CEx.: Comparative Example, RT: Room temperature | | | | | | | | | | | | | |

## Claims

1. A silicon nitride sintered body containing at least one element selected from the group consisting of Ti, Ge, Zr, Ag, Ba, and Hf in silicon nitride grains constituting the sintered body, the at least one element being contained as a solid solution in the silicon nitride grains at a concentration of 0.01% to 0.15% by mass.

2. The silicon nitride sintered body according to claim 1, wherein the total concentration of elements P, Cr, Mn, and Fe contained as a solid solution in the silicon nitride grains is 0.05% by mass or less.
